(19) Europäisches Patentamt
European Patent Office
Office européen des brevets

(11) Publication number: **0 172 229**
**B1**

(12) **EUROPEAN PATENT SPECIFICATION**

(45) Date of publication of patent specification: **17.05.89**

(51) Int. Cl.$^4$: **H 03 K 5/15**

(21) Application number: **85901189.2**

(22) Date of filing: **01.02.85**

(86) International application number: **PCT/US85/00184**

(87) International publication number: **WO 85/03817 29.08.85 Gazette 85/19**

(54) **HIGH SPEED CMOS CIRCUITS.**

(30) Priority: **15.02.84 US 580232**

(43) Date of publication of application: **26.02.86 Bulletin 86/09**

(45) Publication of the grant of the patent: **17.05.89 Bulletin 89/20**

(84) Designated Contracting States: **BE DE FR GB NL SE**

(56) References cited:
**US-A-4 069 429**

**Patent Abstracts of Japan,volume 4,no.170,22 November 1980,page E-35 (652) & JP,A,55118226**

**Patent Abstracts of Japan,volume 4,no.181,13 December 1980,page E-37 (663) & JP,A,55124326**

(73) Proprietor: **AMERICAN TELEPHONE AND TELEGRAPH COMPANY**
**550 Madison Avenue**
**New York, NY 10022 (US)**

(72) Inventor: **SHOJI, Masakazu**
**4 Highmount Avenue**
**Warren, NJ 07060 (US)**

(74) Representative: **Buckley, Christopher Simon Thirsk et al**
**AT&T (UK) LTD. AT&T Intellectual Property Division 5 Mornington Road**
**Woodford Green, Essex IG8 0TU (GB)**

**EP 0 172 229 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

1. Field of the Invention

This invention relates to semiconductor integrated circuits (ICs) and more particularly to complementary-metal-oxide-semiconductor (CMOS) circuits (or bipolar circuits) in which signals are applied to two or more multiple-element paths for interaction at a later time.

Background of the Invention

CMOS integrated circuit chips including a plurality of multiple-element electrical paths to which signals are applied are well known in the art. A typical example of such an arrangement comprises two paths intended for a pair of clock signals (one being the complement of the other). Each path includes a plurality of inverters connected electrically in a cascaded arrangement. Signals are applied simultaneously to inputs to such paths for later recombination at a clocked gate.

Multipath circuits of this type are characterized by delays which cause skew thus reducing the clock rate at which such circuits are capable of operating. In this connection, the term "skew" refers to the actual time of occurrence of a pulse with respect to the expected time of occurrence. At present, the sum of the delays of one path are set to equal the sum of the delays in the other under "worst-case" processing conditions to reduce skew. Setting the total delays of one path equal to the total in the other does not correct for process-induced variations in delays under all conditions.

Brief Summary of the Invention

This invention is based on the recognition that a significant reduction in skew normally introduced by process variations is achieved by setting the sizes of the inverters in each path so that the sums of the pull-up delays of the elements in the two paths are equal and the sums of the pull-down delays in the two paths are also equal (note that total delays also are equal in this case). The result is a multipath logic circuit relatively free not only of process-induced variations but voltage and temperature-induced variations as well. Devices made in accordance with the teachings of this invention are characterized by field effect transistors (PFETs and NFETs) chosen such that the widths of the PFETs and NFETs in one path are related functionally to the widths of the PFETs and NFETs in the other. In this connection, the term (gate) "length" refers to the length of the curerent path between a source and drain of a PFET or an NFET and the term (gate) "width" refers to the transverse dimension of the P or N channel region of the PFET or the NFET.

Brief Description of the Drawing

FIG. 1 is a circuit diagram of a prior art circuit which can be designed in accordance with the principles of this invention; and

FIGS. 2 and 3 are graphical representations of the output waveforms of the circuit of FIG. 1 defining the delays of various elements in the circuit.

Detailed Description

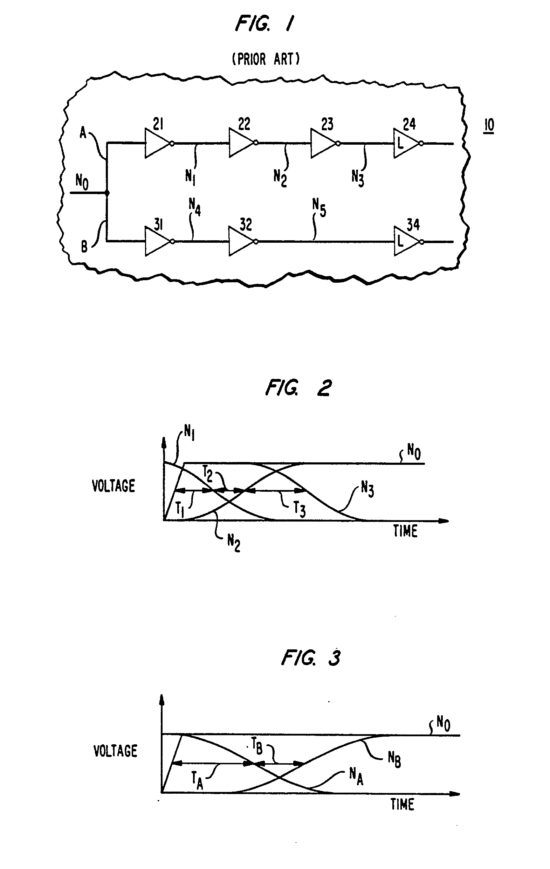

FIG. 1 shows a fragment 10 of a semiconductor chip in which first and second logic paths A and B are shown with three and two inverter logic chains, respectively. The inverters of path A are designated 21, 22, and 23, as shown, and are connected between an internal node $N_0$ and the input to a load which may be inverter 24. Similarly, path B includes inverters 31 and 32 connected between node $N_0$ and the input to a load comprising inverter 34. Node $N_0$ may comprise a connection to a clockbus of a microprocessor in which case the circuit of FIG. 1 comprises a portion of the input-output (I/O) frame of the microprocessor.

It has been found that the signal delays in those paths can be expressed as a product of, basically, two functional terms. One of these terms is a function of dimensionless factors determined only by transistor sizes chain of inverters is derived as follows: Consider an N-stage chain of inverters and let us represent the size of the P and N field effect transistors (PFETs and NFETs) in the chain in microns as $P_i$ and $N_i$. We will assume (arbitrarily) that the (N + 1)th stage is the load and that the first stage is driven by a low impedance pulse source and is usually the case. For the case where the input voltage makes a low to high transition, the total delay of the chain can be represented as

$$T_{d(\uparrow)} = \frac{C}{\mu_N(V_{DD}-V_{THN})} \times \frac{(P_2+N_2) + f(P_1+N_1)}{N_1}$$

$$+ \frac{C}{\mu_P(V_{DD}-V_{THP})} \times \frac{(P_3+N_3) + f(P_2+N_2)}{P_2}$$

$$+ \ldots\ldots\ldots\ldots + \qquad (1)$$

$$+ \frac{C}{\mu_P(V_{DD}-V_{THN})} \times \frac{(P_{n+1}+N_{n+1}) + f(P_n+N_n)}{N_n}$$

(if n is an odd number) or

$$+ \frac{C}{\mu_P(V_{DD}-V_{THP})} \times \frac{(P_{n+1}+N_{n+1}) + f(P_n+N_n)}{P_n}$$

(if n is an even number)

where C is a universal proportionality constant, $\mu_N$ and $\mu_p$ are the electron and hole mobilities, and $V_{THN}$ and $V_{THP}$ are the threshold voltages of the NFETs and PFETs, respectively. The delay for a high to low transition of the input voltage can be written in the same way.

The factor *f* in Equation 1 is a dimensionless factor specifying the ratio of drain capacitance to gate capacitance. Accordingly, $T_d$ may be represented as (widths) in the consecutive inverters of the chains of inverters of a pair of multi-element paths. Another of those terms is a function of processing, temperature and voltage dependent parameters. We can express the delays as the sum of two distinct terms because pull-up FETs are always PFETs and pull-down FETs are always NFETs, and because PFETs and NFETs are processed under different conditions yet both contribute to delay.

More specifically, it has been realized that processing variations result in uncontrollable changes in the length of the current path between the source and drain (the gate length) of a transistor. Such variations manifest themselves as changes in conductance which determines the delay characteristic of the transistor. By representing the equation for the delay time as a sum of two terms where the first term includes only elements which represent PFETs and the second term includes only elements which represent NFETs, each term may be represented as a product of dimensionless factors and a factor influenced by processing temperature and voltage. If each product term of the delay equations for the two paths are set separately equal to one another, the pull-up and pull-down delays can be specified such that each of the process variable terms in the two equations track one another separately, so that the process variable terms influence those delays in exactly the same way. Actually, because the gate length of a transistor is affected in an uncontrollable manner by processing variations, the only significant factor for achieving essentially zero skew in a pair of circuits is the more controllable gate width and it is the adjustment of that width which provides a control over delay characteristics. Actually, gate length and width are equally affected by processing variations. But gate length is typically one percent of the gate width so that any charge due to processing affects the gate width insignificantly.

The delay characteristic of a path including a

$$T_d(\uparrow) = Q_N \times R_{11} + Q_P \times R_{12} \qquad \text{(and)}$$
$$T_d(\downarrow) = Q_N \times R_{21} + Q_P \times R_{22}$$

where (2)

$$Q_N = \frac{C}{\mu_N(V_{DD}-V_{THN})} \text{ and } Q_P = \frac{C}{\mu_P(V_{DD}-V_{THP})}$$

are the process, temperature and voltage dependent parameters and where $R_{11}$, $R_{12}$, $R_{21}$ and $R_{22}$ are dimensionless factors almost independent of these "physical" parameters, the only small dependence coming from factor *f*.

The delays of two circuits, say circuits A and B of FIG. 1, can be represented as

$$T_D(\uparrow)_A = Q_N R_{11}(A) + Q_P R_{12}(A)$$
$$T_D(\downarrow)_A = Q_N R_{21}(A) + Q_P R_{22}(A) \qquad (3)$$

and

$$T_D(\uparrow)_B = Q_N R_{11}(B) + Q_P R_{12}(B)$$
$$T_D(\downarrow)_B = Q_N R_{21}(B) + Q_P R_{22}(B) \qquad (4)$$

If the circuits are desisgned such that $R_{11}(A) = R_{11}(B)$, $R_{12}(A) = R_{12}(B)$, $R_{21}(A) = R_{21}(B)$ and $R_{22}(A) = R_{22}(B)$, the delays of the two circuits are equal, and also track each other. This result can be seen from Equations 3 and 4 because for the correct choice of transistor sizes, to satisfy conditions $R_{11}(A) = R_{11}(B) \ldots$, those terms of Equations 3 and 4 which are process, temperature or voltage dependent track one another exactly. As a consequence, analog clock systems become feasible, process dependent race conditions can be avoided, a countdown circuit will not have much sensitivity to parameter fluctuation, and skewless inversions of clock signals become feasible.

The circuit of FIG. 1 supplies a pair of CMOS clock pulses. Nodes $N_5$ and $N_3$ of FIG. 1 supply a clock pulse and its inversion. The voltage waveforms for nodes $N_0$—$N_5$ are shown in FIG. 2. Inversion delays $T_1$, $T_2$, $T_3$, $T_A$ and $T_B$ are also defined in that Figure and in FIG. 3. Prior art circuits of this type are designed so that

$$T_1 + T_2 + T_3 = T_A + T_B \qquad (5)$$

for worst-case processsing conditions. Consequently, skew is exhibited by prior art circuits made by "better-case" processing conditions.

According to the principles of the present invention, the circuit having two paths is configured so that

$$T_1 + T_3 = T_A \text{ and } T_2 = T_B \qquad (6)$$

It is clear that in this letter case, the delays due to PFET and NFET devices are separately balanced between the two circuits.

Two versions of the circuit of FIG. 1 were designed with the following FET sizes.

| Gate | Version 1 | Version 2 |
|---|---|---|
| 21 | P = 10 N = 4 | P = 10 N = 4 |
| 23 | P = 32 N = 13 | P = 40 N = 16 |
| 31 | P = 5 N = 2 | P = 7 N = 3 |
| 32 | P = 20 N = 8 | P = 50 N = 20 |
| Load(24 and 34) | P = 106 N = 40 | P = 100 N = 40 |

where P and N are in like units where a unit is 3.75 microns. Version 1 satisfies Equation 5 only; but version 2 satisfies Equation 6 as well. Both versions are skew free at 5.0 V supply voltage ($V_{DD}$), 105 degrees C skew free at 5.0 V supply voltage ($V_{DD}$), 105 degrees C and worst-case processing conditions. But version 1 shows skew for the other processing conditions (see table below). The circuit of version 2 does not.

The skew parameters for versions 1 and 2 are shown in the following Table:

| FET | Version 1 | Version 2 |
|---|---|---|
| N-high current, P-low current | 0.75NS | $\simeq$ 0.00NS |
| N-low current, P-high current | 0.38NS | <0.02NS |

It is clear that all skew can be compensated for by setting the pull-up delays in the two paths equal to one another and the pull-down delays equal to one another.

**Claims**

1. An integrated circuit chip including first and second logic circuits to which electrical signals are applied simultaneously, each of said circuits comprising a plurality of logic elements each having a characteristic pull-up and a pull-down delay, the delays of said signal being functions of dimensions which are controllable and dimensions which are not controllable, characterized in that the sum of the pull-down delays of the elements (21—23) in said first circuit equals the sum of the pull-down delays of the elements (31, 32) in said second circuit and the sum of the pull-up delays of the elements in said first circuit equals the sum of the pull-up delays of the elements of said second circuit such that the effect of changes of dimensions in said first and second circuits which are not controllable track one another.

2. An integrated circuit chip in accordance with claim 1 wherein the dimensions which are controllable comprise the widths of said elements in said first and second circuits.

3. An integrated circuit chip in accordance with claim 2 wherein the numbers of elements in said first and second circuits are different.

4. An integrated circuit chip in accordance with claim 3 wherein all said pull-up and all said pull-down transistors are formed during first and second processing operations, respectively.

**Patentansprüche**

1. Integrierte Schaltung mit einer ersten und einer zweiten Logikschaltung, an die gleichzeitig elektrische Signale angelegt werden und die je eine Vielzahl von Logikelementen mit je einer charakteristischen Einschalt- und Ausschaltverzögerung aufweisen, wobei die Vorzögerungen der Signale eine Funktion von kontrollierbaren und von nicht kontrollierbaren Abmessungen sind, dadurch gekennzeichnet, daß die Summe der Ausschaltverzögerungen der Logikelemente (21—23) in der ersten Schaltung gleich der Summe der Ausschaltverzögerungen der Logikelemente (31, 32) in der zweiten Schaltung und die Summe der Einschaltverzögerungen der Logikelemente in der ersten Schaltung gleich der Summe der Einschaltverzögerungen der Logikelemente in der zweiten Schaltung ist, derart, daß der Einfluß von Abweichungen der nicht kontrollierbaren Abmessungen in der ersten und der zweiten Schaltung sich aneinander angleicht.

2. Integrierte Schaltung nach Anspruch 1, bei der die kontrollierbaren Abmessungen die Breite der Logikelemente in der ersten und der zweiten Schaltung umfassen.

3. Integrierte Schaltung nach Anspruch 2, bei der die Anzahl der Logikelemente in der ersten und der zweiten Schaltung unterschiedlich ist.

4. Integrierte Schaltung nach Anspruch 3, bei der alle Einschalt- und alle Ausschalttransistoren bei ersten bzw. zweiten Bearbeitungsoperationen hergestellt werden.

**Revendications**

1. Une puce de circuit intégré comprenant des premier et second circuits logiques auxquels des signaux électriques sont appliqués simultanément, chacun de ces circuits comprenant un ensemble d'éléments logiques ayant chacun un retard caractéristique de transition vers le potentiel d'alimentation haut et de transition vers le potentiel d'alimentation bas, les retards de ces signaux étant fonction de dimensions qui sont contrôlables et de dimensions qui ne sont pas contrôlables, caractérisée en ce que la somme des retards de transition vers le potentiel d'alimentation bas pour les éléments (21—23) dans le premier circuit, est égale à la somme des retards de transition vers le potentiel d'alimentation bas pour les éléments (31, 32) dans le second circuit, et la somme des retards de transition vers le potentiel d'alimentation haut pour les éléments du premier circuit est égale à la somme des retards de transition vers le potentiel d'alimentation haut pour les éléments du second circuit, de façon que des changements de dimensions dans les premier et second circuits qui ne sont pas contrôlables aient des effets qui se suivent.

2. Une puce de circuit intégré selon la revendication 1, dans laquelle les dimensions qui sont contrôlables comprennent les largeurs des éléments dans les premier et second circuits.

3. Une puce de circuit intégré selon la revendication 2, dans laquelle les nombres d'éléments dans les premier et second circuits sont différents.

4. Une puce de circuit intégré selon la revendication 3, dans laquelle tous les transistors de rappel au potentiel d'alimentation haut et tous les transistors de rappel au potentiel d'alimentation bas sont respectivement formés pendant des première et seconde opérations de fabrication.

FIG. 1

(PRIOR ART)

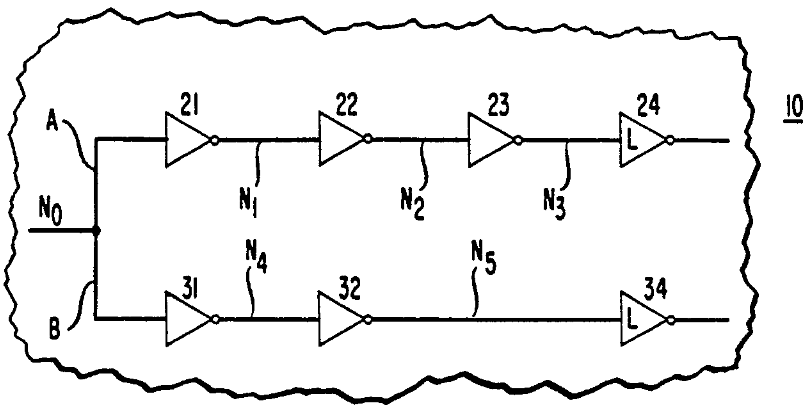


FIG. 2

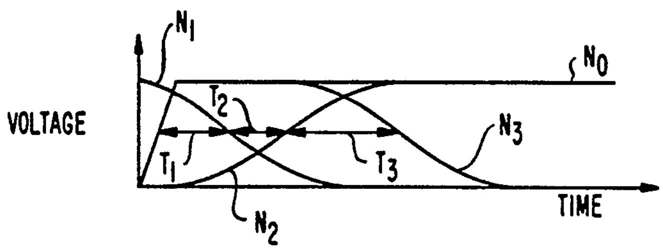


FIG. 3